# EUROPÄISCHE PATENTSCHRIFT

(11) **EP 3 580 526 B1**
(45) Veröffentlichungstag und Bekanntmachung des Hinweises auf die Patenterteilung: **16.09.2020**
(21) Anmeldenummer: 18717207.7
(22) Anmeldetag: 07.03.2018
(51) Int. Cl.: G01D 1/00, G01D 21/00, G01R 27/26

(54) **AUSWERTESCHALTUNG, SYSTEM UND VERFAHREN ZUM AUSWERTEN EINES KAPAZITIVEN ODER INDUKTIVEN SENSORS**
EVALUATING CIRCUIT, SYSTEM, AND METHOD FOR EVALUATING A CAPACITIVE OR INDUCTIVE SENSOR
CIRCUIT D'ÉVALUATION, SYSTÈME ET PROCÉDÉ SERVANT À ÉVALUER UN CAPTEUR CAPACITIF OU INDUCTIF

(30) Priorität: 06.04.2017 DE 102017205908
(43) Veröffentlichungstag der Anmeldung: 18.12.2019
(73) Patentinhaber: Czardybon, Peter, 68309 Mannheim (DE); Czardybon, Marius, 68307 Mannheim (DE)
(72) Erfinder: CZARDYBON, Peter, 68309 Mannheim (DE)
(74) Vertreter: Patent- und Rechtsanwälte Ullrich & Naumann
(86) Internationale Anmeldenummer: PCT/DE2018/200022
(87) Internationale Veröffentlichungsnummer: WO 2018/184638

(56) Entgegenhaltungen:
- EP-A1- 0 166 706
- EP-A2- 1 860 776
- DE-A1- 19 520 948
- DE-A1-102014 216 998
- US-A1- 2008 303 536

## Beschreibung

Die vorliegende Erfindung betrifft eine Auswerteschaltung zum Auswerten eines kapazitiven oder induktiven Sensors, sowie ein entsprechendes System und Verfahren.

Kapazitive und induktive Sensoren finden in vielen Bereichen der Technik Anwendung. Üblicherweise werden derartige Sensoren dazu verwendet, um den Abstand oder die Position eines Messobjekts oder deren Veränderung relativ zu dem Sensor zu bestimmen. Hierbei wird ausgenutzt, dass Messobjekte eine Rückwirkung auf den Sensor bzw. dessen Sensorelemente haben. Üblicherweise äußert sich diese Rückwirkung in einer messbaren Änderung der Impedanz des Sensors bzw. eines Sensorelements des Sensors. Wenn sich beispielsweise ein leitfähiges Messobjekt einem nach dem Wirbelstromprinzip arbeitenden induktiven Sensor nähert, so induziert ein durch den Sensor ausgesendetes Magnetfeld in dem Messobjekt Wirbelströme. Diese Wirbelströme wirken der Änderung des Magnetfelds entgegen, so dass sich die Induktivität der Sensorspule und damit deren Impedanz ändert. Ein nichtleitendes Messobjekt, das sich einem kapazitiven Sensor nähert, wirkt als Dielektrikum und erhöht dadurch die Kapazität des Sensors. Dies führt wiederum zu einer Änderung der Impedanz des Sensors. Entsprechendes gilt für andere Technologien von kapazitiven und induktiven Sensoren.

Derartige Impedanzänderungen sind üblicherweise nicht unmittelbar nutzbar. Vielmehr werden die Impedanzänderungen durch eine Auswerteschaltung in ein Messsignal gewandelt, das dann weiterverarbeitet werden kann. Dabei werden häufig die Sensorelemente des Sensors durch Beschaltungselemente zu einem Parallel- oder Serienschwingkreis ergänzt und der Schwingkreis mit einer Wechselspannung beaufschlagt. Nähert sich ein Messobjekt dem Einflussbereich des Sensors, so wird der Schwingkreis verstimmt, was zu einer detektierbaren Phasenverschiebung zwischen dem Schwingkreissignal und dem Anregungssignal führt. Nachteilig dabei ist, dass hierdurch weitere Abhängigkeiten eingeführt werden, wie beispielsweise Abhängigkeiten von der Länge eines Anschlusskabels, Temperaturabhängigkeiten und zusätzlichen Bauteiltoleranzen. Ferner müssen die Bauteile, die zum Bilden des Schwingkreises notwendig sind, nahe bei dem Sensor angeordnet sein, was nicht in allen Anwendungsszenarien möglich ist.

Andere Auswerteschaltungen nutzen einen differentiellen Ansatz, bei dem die Impedanzen zweier Sensorelemente eines Sensors oder eines Sensorelements eines Sensors mit einem Referenzelement verglichen werden. Eine derartige Schaltung ist beispielsweise aus der EP 0 166 706 A1 bekannt. Ein Oszillator wird mittels Schalter abwechselnd auf eine Referenzkapazität und eine Sensorkapazität geschaltet. Das Steuersignal der Schalter wird durch einen Frequenzteiler aus den Schwingungen des Oszillators, dessen Flanken durch einen Schnitt-Trigger aufbereitet sind, gebildet. Das Steuersignal für die Schalter wird mit einer Aufbereitungsschaltung in ein differentielles Signal gewandelt und als differentielles Ausgangssignal der Schaltung ausgegeben.

Aus der DE 38 18 371 A1 ist eine Auswerteschaltung für einen differentiellen induktiven Geber mit zwei Sensorspulen bekannt, wobei die Sensorspulen durch eine gemeinsame Kapazität zu einem LC-Schwingkreis ergänzbar sind. Die beiden Sensorspulen weisen einen gemeinsamen Anschluss auf, der mit einem von zwei Anschlüssen eines Oszillators verbunden ist. Der zweite Anschluss des Oszillators ist mit einer Schaltvorrichtung verbunden, die den Oszillator abwechselnd mit dem zweiten Anschluss einer der beiden Sensorspulen verbindet. Dadurch wird abwechselnd eine der beiden Sensorspulen zu Schwingungen angeregt.

Nachteilig an diesen Auswerteschaltungen ist, dass ein Schaltelement notwendig ist, was die Kosten und die Fehleranfälligkeit der Schaltung erhöht.

Andere Auswerteschaltungen, mit denen kapazitive Sensoren ausgewertet werden können, sind in der DE 10 2014 216 998 A1, EP 1 860 776 A2, DE 195 20 948 A1 und der US 2008/0303536 A1 offenbart.

Der vorliegenden Erfindung liegt die Aufgabe zugrunde, eine Auswerteschaltung, ein System und ein Verfahren der eingangs genannten Art derart auszugestalten und weiterzubilden, dass eine zuverlässige und kostengünstige differentielle Auswertung eines kapazitiven oder induktiven Sensors ermöglicht wird.

Erfindungsgemäß ist die voranstehende Aufgabe durch die Merkmale des Anspruchs 1 gelöst. Danach umfasst die in Rede stehende Auswerteschaltung:
einen ersten und einen zweiten Messanschluss, wobei der erste Messanschluss zum Verbinden eines ersten Sensorelements des Sensors und der zweite Messanschluss zum Verbinden eines zweiten Sensorelements des Sensors oder eines Referenzelements ausgebildet ist,
eine Lade- und Entladeschaltung, die zum Ausgeben eines ersten Lade- und Entladesignals an den ersten Messanschluss und zum Ausgeben eines zweiten Lade- und Entladesignals an den zweiten Messanschluss ausgebildet ist,
eine Komparatorschaltung, die das zeitliche Verhalten des ersten Lade- und Entladesignals mit dem zeitlichen Verhalten des zweiten Lade- und Entladesignals vergleicht, und
eine Integratorschaltung, die mit einem Ausgang der Komparatorschaltung verbunden ist und deren Ausgangsspannung sich in Abhängigkeit von der Spannung am Ausgang der Komparatorschaltung ändert und
wobei die Ausgangsspannung der Integratorschaltung zum Anpassen des ersten Lade- und Entladesignals auf den ersten Messanschluss oder zum Anpassen des zweiten Lade- und Entladesignals auf den zweiten Messanschluss geschaltet ist,
wobei ein Messsignal an einem Ausgang der Auswerteschaltung von der Ausgangsspannung der Integratorschaltung abgeleitet ist und wobei das Messsignal ein Maß für die Abweichung der Impedanzen des ersten und des zweiten Sensorelements oder der Impedanzen des ersten Sensorelements und des Referenzelements ist.

Hinsichtlich des Systems ist die voranstehenden Aufgabe durch die Merkmale des nebengeordneten Anspruchs 11 gelöst. Dieses System umfasst eine erste und zweite Auswerteschaltung nach dem ersten Aspekt der Erfindung, sowie ferner:
einen ersten kapazitiven oder induktiven Sensor mit zwei Sensorelementen und
ein Referenzelement,
wobei das erste Sensorelement des ersten Sensors mit einem ersten Messanschluss der ersten Auswerteschaltung und das zweite Sensorelement des ersten Sensors mit einem zweiten Messanschluss der ersten Auswerteschaltung verbunden ist,
wobei das Referenzelement mit einem zweiten Messanschluss der zweiten Auswerteschaltung verbunden ist und
wobei der erste Messanschluss der zweiten Auswerteschaltung über jeweils einen Koppelwiderstand mit dem ersten und dem zweiten Messanschluss der ersten Auswerteschaltung verbunden ist.

In verfahrensmäßiger Hinsicht ist die voranstehende Aufgabe durch die Merkmale des nebengeordneten Anspruchs 15 gelöst. Danach umfasst das in Rede stehende Verfahren die Schritte:
Erzeugen eines ersten und eines zweiten Lade- und Entladesignals,
wiederholtes Laden und Entladen eines ersten Sensorelements des Sensors mittels des ersten Lade- und Entladesignals,
wiederholtes Laden und Entladen eines zweiten Sensorelements des Sensors oder eines Referenzelements mittels des zweiten Lade- und Entladesignals,
Vergleichen des zeitlichen Verhaltens des ersten Lade- und Entladesignals mit dem zeitlichen Verhalten des zweiten Lade- und Entladesignals,
Ändern einer Ausgangsspannung einer Integratorschaltung in Abhängigkeit von dem Ergebnis des Vergleichs der zeitlichen Verhalten,
Anpassen des ersten Lade- und Entladesignals und/oder der zweiten Lade- und Entladesignals in Abhängigkeit von der Ausgangsspannung der Integratorschaltung und
Ableiten und Ausgeben eines Messsignals aus der Ausgangsspannung der Integratorschaltung als ein Maß für die Abweichung der Impedanzen des ersten und des zweiten Sensorelements oder der Impedanzen des ersten Sensorelements und des Referenzelements.

In erfindungsgemäßer Weise ist zunächst erkannt worden, dass durch eine relativ einfache Regelschleife ein (analoges) Messsignal erzeugt werden kann, das ein Maß für die Abweichung zweier Impedanzen bildet, nämlich eines ersten Sensorelements relativ zu einem zweiten Sensorelement oder ein erstes Sensorelement relativ zu einem Referenzelement. Hierbei wird ausgenutzt, dass das zeitliche Verhalten eines Lade- und Entladesignals, das auf eine Impedanz gegeben wird, von der Impedanz abhängig ist. Bei einer Kapazität ist das Lade- und Entladeverhalten von der Größe der Kapazität abhängig: Je größer die Kapazität desto langsamer wird die Kapazität auf einen maximalen Spannungswert aufgeladen. Umgekehrt wird eine Kapazität umso langsamer entladen, je größer die Kapazität ist. Entsprechendes gilt auch für eine Spule, bei der der Strom durch die Spule bei einem Spannungssprung in Abhängigkeit von der Induktivität der Spule schneller oder langsamer ansteigt. Wenn also das zeitliche Verhalten zweier Impedanzen in Reaktion auf ein Anregungssignal verglichen wird, ergibt sich daraus ein Maß für die Abweichungen der Impedanzen.

Erfindungsgemäß wird daher mittels einer Lade- und Entladeschaltung ein erstes und ein zweiter Lade- und Entladesignal erzeugt und an Messanschlüssen der Auswerteschaltung ausgegeben. Dabei wird das erste Lade- und Entladesignal an einen ersten Messanschluss und das zweite Lade- und Entladesignal an einen zweiten Messanschluss ausgegeben. Der erste Messanschluss ist zum Verbinden eines ersten Sensorelements des Sensors ausgebildet. An den zweiten Messanschluss kann entweder ein zweites Sensorelement des Sensors oder ein Referenzelement angeschlossen werden. Die Lade- und Entladeschaltung ist derart ausgeschaltet, dass das erste und zweite Lade- und Entladesignal jeweils eine Abhängigkeit von den Impedanzen aufweist, die an den ersten bzw. zweiten Messanschluss angeschlossen sind. In der Praxis wird diese Abhängigkeit meist darin bestehen, dass das zeitliche Verhalten des Lade- und Entladesignals beeinflusst wird. Wenn beispielsweise ein Rechtecksignal ein Anregungssignal bildet, so werden die Flanken des Rechtecksignals durch die angeschlossene Impedanz abgeflacht. Je größer die Impedanz ist, desto stärker ist die Abflachung. Dadurch ändert sich das Lade- und Entladesignal in Abhängigkeit der angeschlossenen Impedanz.

Zum Ausnutzen dieser Abhängigkeiten umfasst die Auswerteschaltung einen Komparator der das zeitliche Verhalten des ersten Lade- und Entladesignals mit dem zeitlichen Verhalten des zweiten Lade- und Entladesignals vergleicht. Je nach Ergebnis des Vergleichs gibt der Komparator ein Ergebnissignal aus, das repräsentativ für das relative zeitliche Verhalten ist. Üblicherweise wird dieses Ergebnissignal ein binäres Signal sein, d.h. das Signal kann zwei Pegel annehmen. Dabei zeigt der erste Pegel an, dass das erste Lade- und Entladesignal schneller ansteigt und/oder abfällt als das zweite Lade- und Entladesignal. Entsprechend zeigt der zweite Pegel an, dass das zweite Lade- und Entladesignal schneller ansteigt und/oder abfällt als das erste Lade- und Entladesignal. Das Ergebnissignal wird dann einer Integratorschaltung zugeführt, die die Vergleichsergebnisse aufsummiert. Am Ausgang der Integratorschaltung liegt dann eine Spannung an, die repräsentativ für die Anzahl von Erhöhungsschritten der Integratorschaltung ist.

Damit die Erhöhung der Ausgangsspannung nicht unbegrenzt ansteigt, wird die Ausgangsspannung auf einen der Messanschlüsse geschaltet. Dadurch wird das Lade- und Entladesignal mit einem Gleichspannungspegel überlagert, so dass das Lade- und Entladesignal zu positiven oder zu negativen Spannungen verschoben wird, je nach Ausgestaltung der Schaltung. Damit wird wiederum der Zeitpunkt verschoben, an dem ein bestimmter Pegel des Lade- und Entladesignals erreicht wird. Dadurch kann erreicht werden, dass sich das Ergebnissignal aus der Komparatorschaltung ändert und damit statt des ersten Pegels den zweiten Pegel (oder umgekehrt) annimmt. Dies führt dazu, dass die Ausgangsspannung nicht mehr weiter erhöht wird. Auf diese Weise ist die Spannung am Ausgang der Integratorschaltung ein Maß dafür, wie stark die Impedanzen an dem ersten und dem zweiten Messanschluss voneinander abweichen. Dabei ist erfindungsgemäße Auswerteschaltung kostengünstig und liefert selbst für sehr kleine Impedanzen der Sensorelemente gute Ergebnisse. Zudem können Abhängigkeiten von Temperatur und Kabellängen einfach eliminiert werden, wenn die Kabel zwischen den Messanschlüssen und den Sensorelementen annähernd gleich lang sind und nahe beieinander geführt werden. Da die Integratorschaltung und die Komparatorschaltung keine Präzisionsbauelemente benötigen, sondern vielmehr mit Standardkomponenten aufgebaut werden können, entsteht eine kostengünstige Auswerteschaltung.

Es sei darauf hingewiesen, dass die Verwendung der Bezeichnungen "erster Messanschluss" und "zweiter Messanschluss" lediglich zur Unterscheidung der beiden Messanschlüsse dient. Da die Schaltung im Wesentlichen symmetrisch aufgebaut ist, ist es unerheblich, welche der Impedanzen (d.h. ein erstes Sensorelement, ein zweites Sensorelement bzw. das Referenzelement) an welchem Messanschluss angeschlossen ist. Dies gilt unabhängig davon, ob eine Auswerteschaltung als einzelne Einheit oder mehrere Auswerteschaltungen zu einem System zusammengeschaltet sind.

Des Weiteren sei darauf hingewiesen, dass ein Referenzelement durch verschiedenste Bauteile gebildet sein kann. Wesentlich dabei ist, dass das Referenzelement - im Gegensatz zu dem/den Sensorelement/en - nicht durch das Messobjekt beeinflusst wird. Ferner sollte - zum Vereinfachen der Auswertung - das Referenzelement von der gleichen Kategorie sein wie der Sensor, d.h. wenn ein kapazitiver Sensor ausgewertet werden soll, wäre das Referenzelement durch eine Kapazität gebildet; wenn ein induktiver Sensor ausgewertet werden soll, wäre das Referenzelement durch eine Induktivität gebildet. Dabei ist es weiterhin von Vorteil, wenn das Referenzelement über eine hohe Temperaturstabilität verfügt oder wenn das Verhalten des Referenzelements auf Temperaturänderungen gleich oder zumindest ähnlich ist wie bei dem Sensor. Dies ist zwar nicht essentiell für die Genauigkeit des ausgegebenen Messsignal, reduziert aber den Aufwand bei der Aufbereitung des Messsignals nicht unerheblich. Auch die Verwendung von Präzisionsbauteilen für das Referenzelement ist vorteilhaft, wenn auch nicht essentiell. Denn Toleranzen bei dem Referenzelement können prinzipiell durch Kalibrierungsmessungen ausgeblichen werden. Durch die Verwendung eines Präzisionsbauelements können die Kalibrierungsmessungen jedoch deutlich vereinfacht werden oder sogar vollständig entfallen. Darüber hinaus kann das Referenzelement einen festen Wert aufweisen oder kann als anpassbare Spule bzw. Kondensator ausgebildet sein. Dabei kann die Anpassbarkeit mittels den verschiedensten aus der Praxis bekannten Verfahren realisiert sein. Manuell anpassbare Referenzelemente sind ebenso einsetzbar wie elektronisch anpassbare Referenzelemente.

In einer bevorzugten Weiterbildung weist die Auswerteschaltung zusätzlich eine invertierende Schaltung auf, die vorzugsweise durch einen invertierenden Verstärker gebildet ist. In diese invertierende Schaltung wird die Ausgangsspannung der Integratorschaltung eingegeben. Die invertierende Schaltung erzeugt aus dieser Eingangsspannung eine Ausgangsspannung, die eine Spiegelung der Eingangsspannung an einer Bezugsspannung darstellt. Wenn die Bezugsspannung beispielsweise einen Wert von 2,5 Volt aufweist und Ausgangsspannung der Integratorschaltung einen Wert von 3 Volt, so würde die invertierenden Schaltung diesen Wert an der Bezugsspannung spiegeln, d.h. die Ausgangsspannung der invertierenden Schaltung hätte den gleichen Abstand von der Bezugsspannung, würde sich aber "auf der anderen Seite" der Bezugsspannung befinden. Die Ausgangsspannung der invertierenden Schaltung würde in diesem Beispiel dann einen Wert von 2 Volt annehmen. Wenn die Ausgangsspannung der Integratorschaltung steigt, sinkt damit die Ausgangsspannung der invertierenden Schaltung und umgekehrt. Damit ändert sich die Ausgangsspannung der invertierenden Schaltung relativ zu der Bezugsspannung und in Bezug auf die Ausgangsspannung der Integratorschaltung in entgegengesetzter Richtung. Bei einer Implementierung der invertierenden Schaltung durch einen invertierenden Verstärker unter Verwendung eines Operationsverstärkers kann dieser Aspekt dadurch realisiert werden, dass die Ausgangsspannung der Integratorschaltung in den invertierenden Eingang des Operationsverstärkers und die Referenzspannung in den nicht-invertierenden Eingang des Operationsverstärkers eingegeben wird.

Eine erste bevorzugte Verwendung dieser invertierenden Schaltung besteht in der Erhöhung des Pegels des Messsignals. Hierbei würde das Messsignal durch die Spannung zwischen dem Ausgang der Integratorschaltung und dem Ausgang der invertierenden Schaltung abgegriffen werden. Dadurch erhöht sich der Spannungshub bei einer Änderung der Ausgangsspannung an der Integratorschaltung auf den doppelten Wert.

Eine zweite bevorzugte Verwendung dieser invertierenden Schaltung besteht darin, dass die Ausgangsspannung der invertierenden Schaltung zur Anpassung eines der beiden Lade- und Entladesignale verwendet wird. Wenn die Ausgangsspannung der Integratorschaltung auf den ersten Messanschluss geschaltet ist, würde die Ausgangsspannung der invertierenden Schaltung zum Anpassen des zweiten Lade- und Entladesignals auf den zweiten Messanschluss geschaltet. Umgekehrt würde die Ausgangsspannung der invertierenden Schaltung zum Anpassen des ersten Lade- und Entladesignals auf den ersten Messanschluss geschaltet, wenn die Ausgangsspannung der Integratorschaltung auf den zweiten Messanschluss geschaltet ist. Auf diese Weise kann die Anpassung der Lade- und Entladesignals verbessert werden.

Zur Verbesserung des Vergleichsergebnisses der Komparatorschaltung kann die Auswerteschaltung eine erste und eine zweite Binarisierungsschaltung aufweisen, wobei die erste Binarisierungsschaltung mit dem ersten Messanschluss und die zweite Binarisierungsschaltung mit dem zweiten Messanschluss verbunden ist. Die Ausgangsspannungen der Binarisierungsschaltungen würde dann in die Komparatorschaltung eingegeben. Vorzugsweise sind die beiden Binarisierungsschaltungen jeweils durch eine Schmitt-Trigger-Schaltung implementiert. Es sind integrierte Schaltungen verfügbar, bei denen zwei derartige Binarisierungsschaltungen auf einem Chip integriert sind. Dadurch ist deren Verhalten der beiden Binarisierungsschaltungen hinsichtlich Eingangskapazität, Schwellenspannung, Verzögerungszeit, Temperatureinfluss und/oder weiterer Kenngrößen nahezu identisch. Damit bilden die ersten und zweite Binarisierungsschaltung die Signale an dem ersten und zweiten Messanschluss in weitgehend gleicher Weise in ein binäres Signal ab, d.h. ein Signal, das einen ersten oder einen zweiten Pegel annimmt und bei dem der Wechsel zwischen den beiden Pegeln rasch vollzogen wird, meist im Bereich von wenigen Millisekunden oder darunter. Gebräuchliche binarisierte Signale ist beispielsweise ein bipolares Rechtecksignal, das zwischen einem positiven ersten Pegel (z.B. +5V) und einem negativen zweiten Pegel (z.B.-5V) wechselt, oder ein unipolares Rechtecksignal, das zwischen zwei positiven Pegeln, zwei negativen Pegel oder einem positiven/negativen Pegel und 0V wechselt. Gebräuchliche unipolare Rechtecksignale nehmen beispielsweise Pegel von +5V oder 0V an.

In einer bevorzugten Ausgestaltung ist der Komparator durch ein Flipflop gebildet. Als besonders gut geeignet haben sich D-Flipflops erwiesen. Dabei werden eines der beiden Lade- und Entladesignale in den Takteingang und das andere der beiden Lade- und Entladesignale in den Dateneingang eingegeben. Bei Verwendung von Binarisierungsschaltungen kann - ohne Beschränkung der Allgemeinheit - der Ausgang der ersten Binarisierungsschaltung mit dem Takteingang des D-Flipflops und der Ausgang der zweiten Binarisierungsschaltung mit dem Dateneingang des D-Flipflops verbunden sein. Ein D-Flipflop ist meist flankengesteuert und gibt bei einer steigenden Flanke am Takteingang den an dem Dateneingang anliegenden Pegel an den Ausgang aus. Wenn nun das zeitliche Verhalten der Impedanz an dem ersten Messanschluss schneller ist als das der Impedanz an dem zweiten Messanschluss, liegt bei einer steigenden Flanke am Takteingang am Dateneingang noch ein Low-Pegel an. Damit liegt in diesem Fall an dem nicht-invertierenden Datenausgang des D-Flipflops ein Low-Pegel. Wenn das zeitlichen Verhalten der Impedanz an dem zweiten Messanschluss schneller ist als das der Impedanz an dem ersten Messanschluss, liegt bei einer steigenden Flanke am Takteingang am Dateneingang noch ein Low-Pegel an. Damit liegt an dem nicht-invertierenden Datenausgang des D-Flipflops in diesem Fall ein Low-Pegel.

Die Integratorschaltung kann prinzipiell auf verschiedenste Weisen implementiert sein. Eine bevorzugte Integratorschaltung ist jedoch als Operationsverstärker-Schaltung implementiert. Derartige Integratorschaltungen sind aus Praxis hinlänglich bekannt. Im einfachsten Fall wird der Ausgang des Operationsverstärkers über einen Kondensator an den invertierenden Eingang zurückgekoppelt. Der Eingang der Integratorschaltung ist durch den invertierenden Eingang des Operationsverstärkers gebildet, so dass das Ausgangssignal der Komparatorschaltung in dieser Ausgestaltung auf den invertierenden Eingang des Operationsverstärkers geschaltet ist.

In einer besonders bevorzugten Weiterbildung ist der nicht-invertierende Eingang des als Integratorschaltung verschalteten Operationsverstärkers mit einer Spannung ungleich 0V, besonders bevorzugter Weise eine Spannung größer 0V beaufschlagt. Auf diese Weise kann die Ausgangsspannung der Integratorschaltung mit einem Offset versehen werden. Dabei wird diese Spannung am nicht-invertierenden Eingang vorzugsweise durch einen Spannungsteiler aus einer Versorgungsspannung der Auswerteschaltung erzeugt. Je nach Wahl des Verhältnisses der Widerstände des Spannungsteilers kann die Offset-Spannung verschoben werden. Vorzugsweise habe beide Widerstände des Spannungsteilers annähernd gleiche Werte, so dass die Offset-Spannung die Hälfte der Versorgungsspannung ist. Vorzugsweise sind die Widerstände des Spannungsteilers Präzisionswiderstände und weisen eine Toleranz von 1 % oder weniger auf.

Vorzugsweise weist die Auswerteschaltung einen Takteingang auf, in den ein Taktsignal eingegeben werden kann. Dieser Takteingang kann mit der Lade- und Entladeschaltung verbunden sein und zum Erzeugen der ersten und zweiten Lade- und Entladesignale genutzt werden. In diesem Fall kann die Lade- und Entladeschaltung in der einfachsten Ausgestaltung durch einen Widerstand oder eine Verschaltung mehrerer Widerstände gebildet sein. Auf diese Weise ist es zum einen möglich, ein periodisches Lade- und Entladesignal zu erzeugen, und zum anderen zu gewährleisten, dass das Lade- und Entladesignal durch eine an dem Messanschluss angeschlossene Impedanz beeinflussbar bleibt.

In einer ersten Ausgestaltung kann ein Taktsignal durch eine externe Taktgeberschaltung, vorzugsweise einen externen Oszillator, gebildet sein, d.h. durch eine Taktgeberschaltung, die nicht zu der betreffenden Auswerteschaltung gehört. In einer zweiten und bevorzugten Ausgestaltung weist die Auswerteschaltung eine Taktgeberschaltung auf, deren Ausgang mit dem Takteingang der Auswerteschaltung verbunden ist. Die Taktgeberschaltung kann dabei durch einen einfachen Oszillator gebildet sein. Wenn beide Lade- und Entladesignale aus einem gemeinsamen Taktsignal hergeleitet werden, sind an den Oszillator keine besonderen Anforderungen hinsichtlich Taktstabilität notwendig, da beide mit dem Messanschluss verbundene Impedanzen von der gleichen Schwankung der Frequenz und/oder dem gleichen Jitter betroffen sind und sich die Fehler damit ausgleichen.

Prinzipiell kann die erfindungsgemäße Auswerteschaltung als einzelne Einheit zum Auswerten eines Sensorelements relativ zu einem anderen Sensorelement oder relativ zu einem Referenzelement genutzt werden. Besondere Effekte ergeben sich jedoch, wenn mehrere Auswerteschaltungen zu einem System zum Auswerten eines kapazitiven oder induktiven Sensors zusammengeschaltet sind.

Ein derartiges erfindungsgemäßes System weist eine erste Auswerteschaltung, eine zweite Auswerteschaltung, einen ersten kapazitiven oder induktiven Sensor und ein Referenzelement auf. Prinzipiell wäre es denkbar, die erste und zweite Auswerteschaltung durch eine relativ beliebiger, aus dem Stand der Technik bekannte Auswerteschaltung zu bilden. Besonders gut funktioniert das System aber dann, wenn die beiden Auswerteschaltungen durch erfindungsgemäße Auswerteschaltungen gebildet sind. Die Auswerteschaltungen weisen jeweils einen ersten und einen zweiten Messanschluss auf. Ein erstes Sensorelement des ersten Sensors ist mit dem ersten Messanschluss der ersten Auswerteschaltung und ein zweites Sensorelement des ersten Sensors mit dem zweiten Messanschluss der ersten Auswerteschaltung verbunden. Das Referenzelement ist mit dem zweiten Messanschluss der zweiten Auswerteeinheit verbunden. Der erste Messanschluss der zweiten Auswerteeinheit wird dazu verwendet, die beiden Auswerteeinheiten untereinander zu koppeln. Denn der erste Messanschluss der zweiten Auswerteeinheit ist mit einem ersten Koppelwiderstand mit dem ersten Messanschluss der ersten Auswerteeinheit und mit einem zweiten Koppelwiderstand mit dem zweiten Messanschluss der ersten Auswerteeinheit verbunden. Auf diese Weise wirken sich Änderungen in den Impedanzen der ersten und zweiten Sensorelemente des ersten Sensors nicht nur auf das Messsignal der ersten Auswerteschaltung, sondern zusätzlich auf das Messsignal der zweiten Auswerteschaltung aus. Damit repräsentiert das Messsignal der ersten Auswerteschaltung eine Abweichung der Impedanzen des ersten und des zweiten Sensorelements des ersten Sensors relativ zueinander, während das Messsignal der zweiten Auswerteschaltung eine Abweichung beider Sensorelemente relativ zu dem Referenzelement repräsentiert. Wenn beispielsweise der Sensor ein kapazitiver Abstandssensor mit zwei Elektroden ist, so repräsentiert das Messsignal der ersten Auswerteschaltung die Position eines Messobjekts relativ zu den beiden Sensorelementen (den Elektroden): Je weiter sich das Messobjekt von einer Mittelposition zwischen den beiden Elektroden entfernt, desto weiter entfernt sich auch das Messsignal von einer Mittelposition, beispielsweise eine Spannung von 0 Volt. Das Messsignal der zweiten Auswerteschaltung gibt hingegen an, wie groß der Einfluss des Messobjekts auf beide Elektroden ist. Wenn das Messobjekt und/oder dessen elektrische Eigenschaften gekannt sind, kann damit aus dem zweiten Messsignal auf den Abstand des Messobjekts relativ zu den Elektroden geschlossen werden.

In einer Weiterbildung dieses erfindungsgemäßen Systems weist das System zusätzlich eine dritte Auswerteschaltung und einen zweiten kapazitiven oder induktiven Sensor auf. Dabei ist die dritte Auswerteschaltung wiederum vorzugsweise durch eine erfindungsgemäße Auswerteschaltung gebildet. Der zweite Sensor ist vorzugsweise von der gleichen Kategorie wie der erste Sensor, d.h. wenn der erste Sensor ein kapazitiver Sensor ist, wäre der zweite Sensor ebenfalls ein kapazitiver Sensor; wenn der erste Sensor durch einen induktiven Sensor gebildet ist, wäre auch der zweite Sensor ein induktiver Sensor. Dabei ist ein erster Messanschluss der dritten Auswerteschaltung mit einem ersten Sensorelement des zweiten Sensors und ein zweiter Messanschluss der dritten Auswerteschaltung mit einem zweiten Sensorelement des zweiten Sensors verbunden. Der erste Messanschluss der dritten Auswerteschaltung ist zusätzlich über einen dritten Koppelwiderstand mit dem ersten Messanschluss der zweiten Auswerteschaltung und der zweite Messanschluss der dritten Auswerteschaltung über einen vierten Koppelwiderstand mit dem ersten Messanschluss der zweiten Auswerteschaltung verbunden. Auf diese Weise erfolgt eine zusätzliche Kopplung der dritten Auswerteschaltung mit der zweiten Auswerteschaltung. In diesem System repräsentiert dann das Messsignal der ersten Auswerteschaltung weiterhin die Abweichung der Impedanzen der beiden Sensorelemente des ersten Sensors. Das Messsignal der dritten Auswerteschaltung repräsentiert die Abweichung der Impedanzen der beiden Sensorelemente des zweiten Sensors. Das Messsignal der zweiten Auswerteschaltung repräsentiert die Abweichung der Impedanzen aller vier Sensorelemente relativ zu dem Referenzelement.

In einer bevorzugten Weiterbildung eines Systems mit zwei Sensoren sind die Sensorelemente des ersten Sensors und die Sensorelemente des zweiten Sensors jeweils symmetrisch zueinander aufgebaut. Vorzugsweise ist die Symmetrie dabei durch eine Achssymmetrie gebildet. Ganz besonders bevorzugter Weise ist dabei die Symmetrieachse der Sensorelemente des ersten Sensors senkrecht zu der Symmetrieachse der Sensorelemente des zweiten Sensors angeordnet.

Bei der Auswertung von kapazitiven Sensoren sind in einem System mit zwei Sensoren die einzelnen Sensorelemente - die Elektroden der Sensoren - vorzugsweise durch Kreisbögen oder Kreissegmente gebildet. Dabei bilden die Kreisbögen der einzelnen Sensorelemente vorzugsweise eine vier Mal unterbrochene Kreislinie bzw. eine in vier Teile untergliederte Kreisfläche.

Bei der Kombination beider Ausgestaltungen, d.h. Sensorelemente mit senkrechten Symmetrieachsen und Kreisbögen oder Kreissegmente als Sensorelemente der beiden Sensoren, würden vier identisch ausgebildete Kreisbögen oder Kreissegmente entstehen, wobei sich jeweils die Elektroden der beiden Sensoren abwechseln. Bei dieser Ausgestaltung der Elektroden ergibt sich ein weiterer Vorteil. Denn das System bildet ein 3D-Sensorsystem: Die Messsignale der ersten und dritten Auswerteschaltung repräsentieren die Positionsabweichung eines Messobjekts vom Kreismittelpunkt, während das Messsignal der zweiten Auswerteschaltung den Abstand des Messobjekts in einer Ebene parallel zu den Elektroden repräsentiert. Dabei gibt das Messsignal der ersten Auswerteschaltung eine Positionsabweichung in Richtung der Symmetrieachse des zweiten Sensors und das Messsignal der zweiten Auswerteschaltung eine Positionsabweichung des Messobjekts in Richtung der Symmetrieachse des ersten Sensors wieder. Damit kann die Position und/oder die Positionsänderung eines Messobjekts in drei Dimensionen erfasst werden.

Ein derartiges Sensorsystem kann verschiedentlich eingesetzt werden. So wäre es denkbar, dass dieses Sensorsystem als 3-dimensionales Eingabegerät verwendet wird. Ein Nutzer könnte ein Objekt, das beispielsweise mittels Federn in einer Mittelposition gehalten ist, aus der dreidimensionalen Mittelposition bewegen und könnte damit in drei Dimensionen eine Richtung vorgeben. Dies kann beispielsweise in Virtual-Reality-Systemen zum Einsatz kommen. Es wäre aber auch denkbar, dass das Sensorsystem in einem Produktionsumfeld genutzt wird, um beispielsweise die Position eines Fertigungsstückes bei einem Arbeitsschritt zu überprüfen. Ein weiteres Anwendungsszenarium könnte darin bestehen, dass eine Position eines Messobjekts gehalten werden soll und mittels des Sensorsystems Abweichungen von der Sollposition bestimmt werden. Diese wenigen Beispiele lassen bereits erkennen, wie universell dieses Sensorsystem einsetzbar ist. Ein Fachmann kann ohne Weiteres erkennen, welche weiteren Anwendungsszenarien sich für das System ergeben.

Zur Synchronisation der einzelnen Auswerteschaltungen weist das System vorzugsweise eine Taktgeberschaltung auf, die vorzugsweise durch einen Oszillator gebildet ist. Ein durch die Taktgeberschaltung erzeugtes Taktsignal würde dann in einen Takteingang der jeweiligen Auswerteschaltungen eingegeben. Auf diese Weise ist gewährleistet, dass die einzelnen Lade- und Entladesignale korrekt in eine zeitliche Beziehung zueinander gesetzt werden können. Dabei kann eine derartige Taktgeberschaltung durch eine externe Schaltung gebildet sein, d.h. eine Taktgeberschaltung, die nicht Bestandteil einer der Auswerteschaltungen ist. In einer bevorzugten Ausgestaltung ist die Taktgeberschaltung jedoch Bestandteil einer der Auswerteschaltungen. Ein Taktausgang dieser Taktgeberschaltung würde dann mit dem Takteingang jeder Auswerteschaltung verbunden, auch der Auswerteschaltung, die die Taktgeberschaltung enthält. Prinzipiell ist denkbar, dass in dieser Ausgestaltung lediglich eine der Auswerteschaltungen eine Taktgeberschaltung aufweist. Da die Taktgeberschaltung jedoch aus sehr wenigen Elementen bestehen wird und damit nur unwesentliche Zusatzkosten verursacht, weist vorzugsweise jede der Auswerteschaltungen eine Taktgeberschaltung auf, wobei lediglich eine der Taktgeberschaltungen aktiv geschaltet wird. Dies ermöglicht einen universellen Einsatz der Auswerteschaltungen.

Beim Betrieb einer erfindungsgemäßen Auswerteschaltung werden folgende Schritte durchgeführt:
Erzeugen eines ersten und eines zweiten Lade- und Entladesignals,
wiederholtes Laden und Entladen eines ersten Sensorelements des Sensors mittels des ersten Lade- und Entladesignals,
wiederholtes Laden und Entladen eines zweiten Sensorelements des Sensors oder eines Referenzelements mittels des zweiten Lade- und Entladesignals,
Vergleichen des zeitlichen Verhaltens des ersten Lade- und Entladesignals mit dem zeitlichen Verhalten des zweiten Lade- und Entladesignals,
Ändern einer Ausgangsspannung eines Integrators in Abhängigkeit von dem Ergebnis des Vergleichs der zeitlichen Verhalten,
Anpassen des ersten Lade- und Entladesignals oder der zweiten Lade- und Entladesignals in Abhängigkeit von der Ausgangsspannung des Integrators und
Ableiten und Ausgeben eines Messsignals aus der Ausgangsspannung des Integrators als ein Maß für die Abweichung der Impedanzen des ersten und des zweiten Sensorelements oder der Impedanzen des ersten Sensorelements und des Referenzelements.

Es ist zu erkennen, dass diese Schritte auch durchgeführt werden können, wenn die Auswerteschaltung eine invertierende Schaltung aufweist oder Bestandteil eines erfindungsgemäßen Systems ist.

Es gibt nun verschiedene Möglichkeiten, die Lehre der vorliegenden Erfindung in vorteilhafter Weise auszugestalten und weiterzubilden. Dazu ist einerseits auf die den nebengeordneten Ansprüchen nachgeordneten Ansprüche und andererseits auf die nachfolgende Erläuterung bevorzugter Ausführungsbeispiele der Erfindung anhand der Zeichnung zu verweisen. In Verbindung mit der Erläuterung der bevorzugten Ausführungsbeispiele der Erfindung anhand der Zeichnung werden auch im Allgemeinen bevorzugte Ausgestaltungen und Weiterbildungen der Lehre erläutert. In der Zeichnung zeigen
- Fig. 1: ein Schaltbild eines Ausführungsbeispiels einer erfindungsgemäßen Auswerteschaltung,
- Fig. 2: ein Block für ein Blockdiagramm, das die erfindungsgemäße Auswerteschaltung nach Fig. 1 repräsentiert,
- Fig. 3: ein erstes Ausführungsbeispiel eines erfindungsgemäßen Systems mit drei Auswerteschaltungen und zwei Sensoren, deren Sensorelemente auf einer Kreisbahn angeordnet sind, und
- Fig. 4: ein zweites Ausführungsbeispiel eines erfindungsgemäßen Systems mit drei Auswerteschaltungen und zwei Sensoren, deren Sensorelemente durch Segmente eines Kreises gebildet sind.

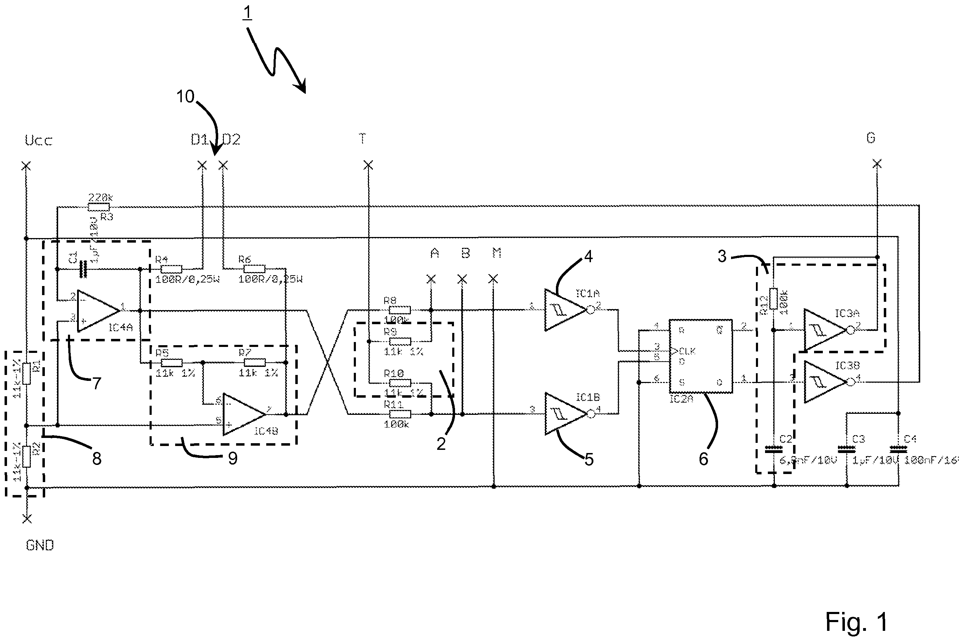

Fig. 1 zeigt ein Schaltbild eines Ausführungsbeispiels einer erfindungsgemäßen Auswerteschaltung. Es sei ausdrücklich darauf hingewiesen, dass die dort verwendeten Werte von Widerständen oder Kondensatoren sowie die Topologie der einzelnen Schaltungselemente lediglich als beispielhafte Dimensionierung und Ausgestaltung der Auswerteschaltung angesehen werden sollte. Ein Fachmann wird erkennen, wie Anpassungen vorgenommen werden können und welchen Effekt diese Anpassungen haben werden.

Die Auswerteschaltung gemäß Fig. 1 weist einen ersten Messanschuss A und einen zweiten Messanschluss B auf, an die jeweils eines von zwei Sensorelementen eines Sensors angeschlossen werden können. Wenn der Sensor ein induktiver Sensor ist, wären die beiden Sensorelemente durch Spulen des Sensors gebildet. Bei einem kapazitiven Sensor wären die beiden Sensorelemente durch Messelektroden des Sensors gebildet. Die Messanschlüsse A, B sind mit einer Lade- und Entladeschaltung 2 verbunden, die in diesem einfachen Fall lediglich durch einen Widerstand R9 und einen Widerstand R10 gebildet ist. Die den Messanschlüssen A, B abgewandten Anschlüsse der Widerstände R9, R10 sind gemeinsam mit einem Takteingang T verbunden. In diesen Takteingang T wird ein Taktsignal eingegeben, das in diesem Ausführungsbeispiel durch eine Taktgebeschaltung 3 erzeugt und an einem Taktausgang G ausgegeben wird. Die Taktgeberschaltung 3 besteht aus einem einfachen Oszillator, der aus einem invertierenden Schmitt-Trigger IC3A, einem Kondensator C2 und einem Widerstand R12 besteht.

Der erste Messanschuss A ist ferner mit einer ersten Binarisierungsschaltung 4, der zweite Messanschluss B mit einer zweiten Binarisierungsschaltung 5 verbunden. Beide Binarisierungsschaltungen 4, 5 sind jeweils durch einen invertierenden Schmitt-Trigger IC1A und IC1B implementiert, wobei der übereinstimmende Anfang der Bezeichnung darauf hinweisen soll, dass die beiden Schmitt-Trigger gemeinsam auf einem Chip integriert sind. Gleichzeitig bedeutet dies, dass sich die beiden Schmitt-Trigger ähnlich verhalten und insbesondere annähernd gleiche Schaltschwellen aufweisen. Die Ausgänge der Binarisierungsschaltungen 4, 5 sind auf Eingänge einer Komparatorschaltung 6 aufgeschaltet. In dem dargestellten Ausführungsbeispiel ist die Komparatorschaltung 6 durch ein D-Flipflop IC2A implementiert, wobei der Ausgang der ersten Binarisierungsschaltung 4 mit dem Takteingang CLK des D-Flipflops IC2A und der Ausgang der zweiten Binarisierungsschaltung 5 mit dem Dateneingang D des D-Flipflops IC2A verbunden ist. Der Setz- und Rücksetzanschluss R, S des D-Flipflops IC2A ist jeweils auf Masse gelegt. Der nicht-invertierte Datenausgang Q des D-Flipflops IC2A ist mit einem weiteren invertierenden Schmitt-Trigger IC3B verbunden, dessen Ausgang über einen Widerstand R3 auf eine Integratorschaltung 7 geschaltet ist. Die Integratorschaltung 7 ist durch einen Operationsverstärker IC4A implementiert, dessen Ausgang über einen Kondensator C1 auf den invertierenden Eingang des Operationsverstärkers IC4A rückgekoppelt ist. Das Signal aus dem invertierenden Schmitt-Trigger IC3B ist über den Widerstand R3 ebenso in den invertierenden Eingang des Operationsverstärkers IC4A eingegeben. Der nicht-invertierenden Eingang des Operationsverstärkers IC4A ist mit dem Mittelabgriff eines Spannungsteilers 8 verbunden, der aus zwei hier identisch bemessenen Widerständen R1 und R2 besteht und zwischen einer Versorgungsspannung Ucc der Auswerteschaltung 1 und Masse geschaltet ist. Der Ausgang der Operationsverstärkers IC4A bildet gleichzeitig den Ausgang der Integratorschaltung 7.

Der Ausgang der Integratorschaltung 7 ist mit einem Eingang einer invertierenden Schaltung 9 verbunden, der in dieser Ausgestaltung durch einen als invertierenden Verstärker verschalteten Operationsverstärker IC4B gebildet ist. Die Beschaltungselemente des Operationsverstärkers IC4B sind durch Widerstände R5 und R7 gebildet, die Präzisionswiderstände sind und eine Verstärkung von -1 einstellen. Der nicht-invertierende Eingang des Operationsverstärkers IC4B ist ebenso mit dem Mittelabgriff des Spannungsteilers 8 verbunden. Der Ausgang des Operationsverstärkers IC4B bildet gleichzeitig den Ausgang der invertierenden Schaltung 9.

Der Ausgang der Integratorschaltung 7 und der Ausgang der invertierenden Schaltung 9 sind über die Widerstände R4 und R6 mit dem Messausgang 10 der Auswerteschaltung 1 verbunden. Die Pins des Messausgangs 10 sind mit D1 und D2 beschriftet. Die Widerstände R4 und R6 dienen im Wesentlichen der Strombegrenzung und sind damit Schutzwiderstände.

Der Ausgang der Integratorschaltung 7 ist über einen Widerstand R11 auf den zweiten Messanschluss B geschaltet. Der Ausgang der invertierenden Schaltung 9 ist über einen Widerstand R8 mit dem ersten Messanschluss A verbunden.

Darüber hinaus weist die Auswerteschaltung 1 einen Masseanschluss M auf, der eine Verbindung mit Masse bereitstellt. Darüber hinaus sind Kondensatoren C3 und C4 vorhanden, die der Stabilisierung der Versorgungsspannung Ucc dienen.

Beim Betrieb der Auswerteschaltung 1 erzeugt die Taktgeberschaltung 3 ein Rechtecksignal, das an dem Takteingang T in die Lade- und Entladeschaltung 2 eingegeben wird. Diese erzeugt ein erstes und zweites Lade- und Entladesignal, das über den ersten und zweiten Messanschluss an ein erstes Sensorelement bzw. ein zweites Sensorelement/ein Referenzelement ausgegeben wird. Die jeweils mit dem ersten bzw. zweiten Messanschluss extern verbundene Impedanz (hier nicht eingezeichnet) erzeugt eine Änderung des zeitlichen Verhaltens der jeweiligen Lade- und Entladesignale. Das dadurch beeinflusste erste und zweite Lade- und Entladesignal wird über die erste und zweite Binarisierungsschaltung 4, 5 jeweils in ein Rechtecksignal gewandelt, das zwischen einem ersten und einem zweiten Pegel wechselt. Das jeweils ausgegebene Rechtecksignal repräsentiert, wann das Lade- und Entladesignal einen ersten Schwellenwert überschreitet oder einen zweiten Schwellenwert unterschreitet. Da invertierende Schmitt-Trigger verwendet werden, bedeutet eine steigende Flanke des Rechtecksignals, dass der zweite Schwellenwert durch das Lade- und Entladesignal unterschritten wurde, während eine fallende Flanke des Rechtecksignals den Zeitpunkt des Überschreitens des ersten Schwellenwerts durch das eingegebene Lade- und Entladesignal kennzeichnet.

Die durch die erste und zweite Binarisierungsschaltung erzeugten Rechtecksignale erzeugen in dem D-Flipflop IC2A folgendes Verhalten: Da die Binarisierungsschaltungen durch invertierende Schmitt-Trigger gebildet sind und da das D-Flipflop auf steigende Flanken am Takteingang CLK reagiert, werden durch die Komparatorschaltung die Entladezweige der Impedanzen an den Messanschlüssen A, B ausgewertet. Wenn die mit Messanschluss A extern verbundene Impedanz schneller unter den Schwellwert entladen ist als die Impedanz an Messanschluss B, wechselt der Pegel des Ausgangssignals der ersten Binarisierungsschaltung 4 auf einen High-Pegel, während der Pegel am Ausgang der zweiten Binarisierungsschaltung 5 noch auf Low-Pegel ist. Auf diese Weise wird bei steigender Flanke am Takteingang CLK ein Low-Pegel an den nicht-invertierten Ausgang Q des D-Flipflops geschaltet. Wenn die mit dem Messanschluss B extern verbundene Impedanz schneller unter den Schwellwert entladen ist als die Impedanz an Messanschluss A, wechselt der Pegel des Ausgangssignals der zweiten Binarisierungsschaltung 5 auf einen High-Pegel, während der Pegel am Ausgang der ersten Binarisierungsschaltung 4 noch auf Low-Pegel ist. Wenn auch die mit Messanschluss A extern verbundene Impedanz unter den Schwellwert entladen ist, entsteht eine steigende Flanke am Ausgang der ersten Binarisierungsschaltung 4, so dass der High-Pegel am Dateneingang D an den nicht-invertierten Datenausgang Q geschaltet wird. Damit zeigt ein Low-Pegel am Datenausgang Q des Flipflops IC2A an, dass die mit Messanschluss A extern verbundene Impedanz schneller entladen ist als die an Messanschluss B extern verbundene Impedanz, während ein High-Pegel anzeigt, dass die mit Messanschluss B extern verbundene Impedanz schneller entladen ist.

Durch den invertierenden Schmitt-Trigger IC3B liegt am Eingang der Integratorschaltung 7 ein High-Pegel an, wenn die mit Messanschluss A extern verbundene Impedanz schneller entladen ist. Ein Low-Pegel liegt an, wenn die mit Messanschluss B extern verbundene Impedanz schneller entladen ist. Im entladenen Zustand der Kapazität C1 liegt aufgrund der Spannung am nicht-invertierenden Eingang des Operationsverstärkers IC4A am Ausgang der Integratorschaltung 7 die halbe Versorgungsspannung U_{cc} an. Das Verhalten der Integratorschaltung 7 hängt nun davon ab, wie die Ausgangsspannung des invertierenden Schmitt-Triggers IC3B aussieht. Im einfachsten Fall wird durch den invertierenden Schmitt-Trigger eine Spannung ausgegeben, die zwischen einer positiven Spannung (üblicherweise U_{cc}) und 0V wechselt. Durch das Beaufschlagen des nicht-invertierten Eingangs des Operationsverstärkers IC4A mit einer Spannung von U_{cc}/2 und aufgrund der Verschaltung des Operationsverstärkers IC4A als Umkehrintegrierer senkt eine positive Spannung am Eingang der Integratorschaltung 7 die Spannung am Ausgang der Integratorschaltung. Umgekehrt steigt die Spannung am Ausgang der Integratorschaltung an, wenn am Eingang der Integratorschaltung 7 ein Pegel von 0V anliegt. Damit reduziert ein schnelleres Entladen am Messanschluss A die Ausgangsspannung des Integrators, während ein schnelleres Entladen am Messanschluss B die Ausgangsspannung des Integrators erhöht.

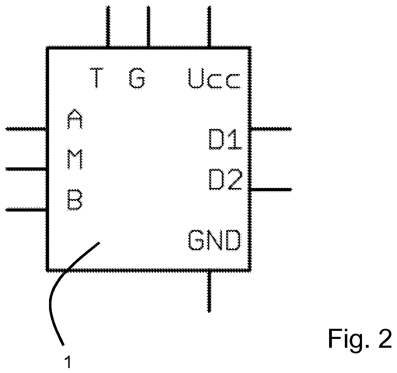

Fig. 2 symbolisiert einen Block, der in den nachfolgenden Blockdiagrammen als Abstraktion der Auswerteschaltung nach Fig. 1 verwendet wird. Die Auswerteschaltung 1 weist auf der linken Seite den ersten und zweiten Messanschluss A, B sowie einen Masseanschluss M auf. An der oberen Seite ist ein Takteingang T, ein Taktausgang G sowie ein Eingang für die Versorgungsspannung Ucc eingezeichnet. An der rechten Seite sind die Pole D1 und D2 eingezeichnet, die gemeinsam den Messausgang 10 bilden. An der unteren Seite ist ein Erdungsanschluss GND dargestellt.

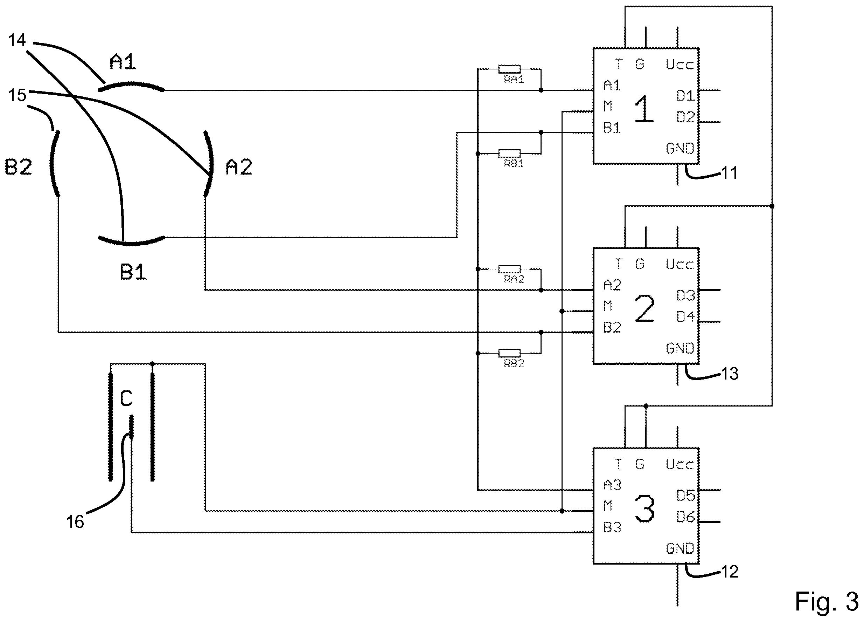

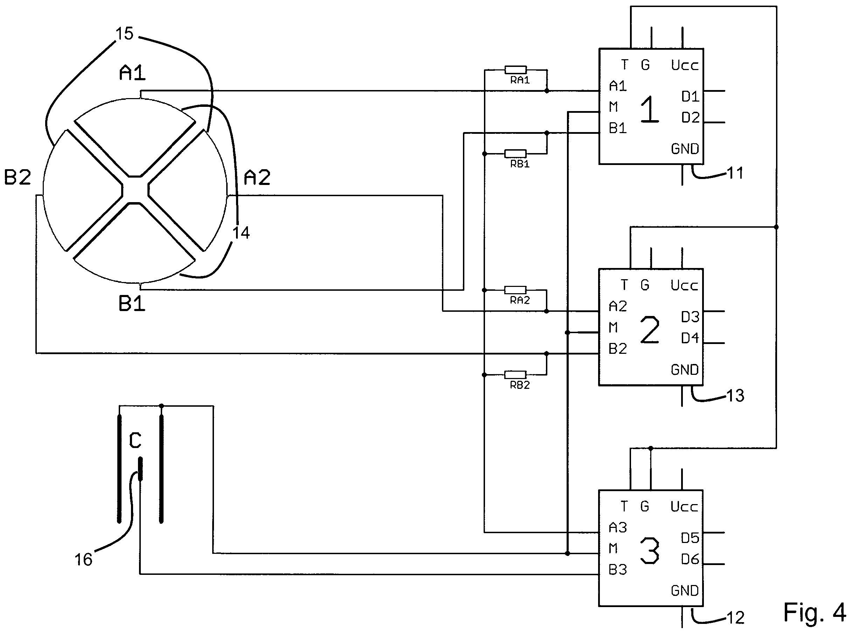

Diese Abstraktion der Auswerteschaltung wird in den Blockschaltbildern der Figuren 3 und 4 verwendet, die zwei Ausführungsbeispiele eines erfindungsgemäßen Systems darstellen. Das Ausführungsbeispiel nach Fig. 3 umfasst eine erste, eine zweite und eine dritte Auswerteschaltung 11, 12, 13 sowie einen ersten und einen zweiten Sensor 14, 15 und ein Referenzelement 16. Die Elektroden/Sensorelemente A1, B1 des ersten Sensors 14 sind achssymmetrisch zu einer horizontalen Linie. Entsprechendes gilt für die Sensorelemente A2, B2 des zweiten Sensors 15, die achssymmetrisch zu einer vertikalen Linie sind. Beide Symmetrieachsen stehen senkrecht aufeinander. Es ist auch die erkennen, dass die vier Sensorelemente A1, A2, B1, B2 gemeinsam auf einer Kreislinie liegen und dass sich stets ein Sensorelement des einen Sensors mit einem Sensorelement des anderen Sensors abwechselt.

Der erste Messanschluss A1 der ersten Auswerteschaltung 11 ist mit einem ersten Sensorelement A1 eines ersten Sensors 14 verbunden. Der zweite Messanschluss B1 der ersten Auswerteschaltung 11 ist mit einem zweiten Sensorelement B1 des ersten Sensors 14 verbunden. Der erste Messanschluss A2 der dritten Auswerteschaltung 13 ist mit einem ersten Sensorelement A2 eines zweiten Sensors 15 verbunden. Der zweite Messanschluss B2 der dritten Auswerteschaltung 13 ist mit einem zweiten Sensorelement B2 des zweiten Sensors 15 verbunden. Der zweite Messanschluss B3 der zweiten Auswerteschaltung 12 ist mit einem Referenzelement 16 verbunden. Der erste Messanschluss A3 ist über einen ersten Koppelwiderstand RA1 mit dem ersten Messanschluss A1 der ersten Auswerteschaltung 11, über einen zweiten Koppelwiderstand RB1 mit dem zweiten Messanschluss B1 der erste Auswerteschaltung 11, über einen dritten Koppelwiderstand RA2 mit dem ersten Messanschluss A2 der dritten Auswerteschaltung 13 und über einen vierten Koppelwiderstand RB2 mit dem zweiten Messanschluss B2 der dritten Auswerteschaltung 13 verbunden. Die Masseanschlüsse M der drei Auswerteschaltungen 11, 12, 13 sind untereinander und mit der Masseelektrode des Referenzelements verbunden. Die Taktgeberschaltung der zweiten Auswerteschaltung 12 ist aktiv, weshalb der Taktausgang G der zweiten Auswerteschaltung 12 mit den Takteingängen T aller drei Auswerteschaltungen 11, 12, 13 verbunden ist. Auf diese Weise sind die Lade- und Entladesignale an allen Messanschlüssen synchron.

Im Betrieb dieses Systems ist zwischen den Polen D1 und D2 der ersten Auswerteschaltung ein Messsignal abgreifbar, das von der Impedanzdifferenz zwischen den Sensorelementen A1, B1 des ersten Sensors 14 abhängig ist. Damit gibt dieses Messsignal an, wie stark sich ein Messobjekt in vertikaler Richtung von einer Mittelposition (der Mittelpunkt des Kreises, auf dem die Sensorelemente liegen) wegbewegt hat. Zwischen den Polen D3 und D4 der dritten Auswerteschaltung ist ein Messsignal abgreifbar, das von der Impedanzdifferenz zwischen den Sensorelementen A2, B2 des zweiten Sensors 15 abhängig ist. Damit gibt dieses Messsignal an, wie stark sich ein Messobjekt in horizontaler Richtung von der Mittelposition wegbewegt hat. Zwischen den Polen D5, D6 der zweiten Auswerteschaltung ist ein Messsignal abgreifbar, das von der Impedanzdiferenz aller vier Sensorelemente A1, A2, B1, B2 relativ zu dem Referenzelement 16 abhängig ist. Dieses Messsignal ist ein Maß für den Abstand des Messobjekts in eine Richtung senkrecht zur Zeichenebene. Das Messobjekt sollte dabei relativ zu dem Sensor klein sein, d.h. die Querschnittsfläche des Messobjekts ist in Richtung Sensor kleiner als der Durchmesser des Sensors. Das Messobjekt kann beispielsweise eine Kugel oder ein mit der Grundfläche in Richtung Sensor gerichteter zylindrischer Stab sein.

Es ist einfach zu erkennen, dass das dargestellte System auch dann gut funktionieren wird, wenn lediglich der erste Sensor, die erste und zweite Auswerteeinheit und das Referenzelement vorhanden sind. In diesem Fall würde sich die Positionserfassbarkeit auf eine horizontale oder vertikale Richtung in der Zeichenebene und eine Richtung senkrecht zur Zeichenebene beschränken.

Das in Fig. 4 dargestellte Ausführungsbeispiel eines erfindungsgemäßen Systems ähnelt dem Ausführungsbeispiel in Fig. 3, wobei die Sensorelemente hier nicht durch Kreisbögen, sondern durch Segmente einer Kreisfläche gebildet sind. Im Übrigen ist die Funktionsweise weitgehend identisch.

Hinsichtlich weiterer vorteilhafter Ausgestaltungen der erfindungsgemäßen Lehre wird zur Vermeidung von Wiederholungen auf den allgemeinen Teil der Beschreibung sowie auf die beigefügten Ansprüche verwiesen.

Schließlich sei ausdrücklich darauf hingewiesen, dass die voranstehend beschriebenen Ausführungsbeispiele lediglich zur Erörterung der beanspruchten Lehre dienen, diese jedoch nicht auf die Ausführungsbeispiele einschränken.

### Bezugszeichenliste

- 1: Auswerteschaltung
- 2: Lade- und Entladeschaltung
- 3: Taktgeberschaltung
- 4: Erste Binarisierungsschaltung
- 5: Zweite Binarisierungsschaltung
- 6: Komparatorschaltung
- 7: Integratorschaltung
- 8: Spannungsteiler
- 9: Invertierende Schaltung
- 10: Messausgang
- 11: Erste Auswerteschaltung
- 12: Zweite Auswerteschaltung
- 13: Dritte Auswerteschaltung
- 14: Erster Sensor
- 15: Zweiter Sensor
- 16: Referenzelement

## Patentansprüche

1. Auswerteschaltung zum Auswerten eines kapazitiven oder eines induktiven Sensors, umfassend:
einen ersten und einen zweiten Messanschluss (A, B), wobei der erste Messanschluss (A) zum Verbinden eines ersten Sensorelements des Sensors (14, 15) und der zweite Messanschluss (B) zum Verbinden eines zweiten Sensorelements des Sensors (14, 15) oder eines Referenzelements (16) ausgebildet ist,
eine Lade- und Entladeschaltung (2), die zum Ausgeben eines ersten Lade- und Entladesignals an den ersten Messanschluss (A) und zum Ausgeben eines zweiten Lade- und Entladesignals an den zweiten Messanschluss (B) ausgebildet ist,
eine Komparatorschaltung (6), die das zeitliche Verhalten des ersten Lade- und Entladesignals mit dem zeitlichen Verhalten des zweiten Lade- und Entladesignals vergleicht, und
eine Integratorschaltung (7), die mit einem Ausgang der Komparatorschaltung (6) verbunden ist und deren Ausgangsspannung sich in Abhängigkeit von der Spannung am Ausgang der Komparatorschaltung (6) ändert und
wobei die Ausgangsspannung der Integratorschaltung (7) zum Anpassen des ersten Lade- und Entladesignals auf den ersten Messanschluss (A) oder zum Anpassen des zweiten Lade- und Entladesignals auf den zweiten Messanschluss (B) geschaltet ist,
wobei ein Messsignal an einem Ausgang (10) der Auswerteschaltung (1) von der Ausgangsspannung der Integratorschaltung (7) abgeleitet ist und wobei das Messsignal ein Maß für die Abweichung der Impedanzen des ersten und des zweiten Sensorelements oder der Impedanzen des ersten Sensorelements und des Referenzelements ist.

2. Auswerteschaltung nach Anspruch 1, **gekennzeichnet durch** eine invertierende Schaltung (9), vorzugsweise einen invertierenden Verstärker, wobei in einen Eingang der invertierenden Schaltung die Ausgangsspannung der Integratorschaltung (7) eingegeben ist, wobei sich eine Ausgangsspannung der invertierenden Schaltung (9) relativ zu einer Bezugsspannung (Ucc/2) in entgegengesetzter Richtung verändert wie die Ausgangsspannung der Integratorschaltung (7).

3. Auswerteschaltung nach Anspruch 1 und 2, **dadurch gekennzeichnet, dass** das Messsignal durch die Spannung zwischen der Ausgangsspannung der Integratorschaltung (7) und der Ausgangsspannung der invertierenden Schaltung (9) gebildet ist.

4. Auswerteschaltung nach Anspruch 1 und 2 oder Anspruch 3, **dadurch gekennzeichnet, dass** die Ausgangsspannung der invertierenden Schaltung (9) zum Anpassen des ersten Lade- und Entladesignals auf den ersten Messanschluss (A) geschaltet ist, wenn die Ausgangsspannung der Integratorschaltung (7) auf den zweiten Messanschluss (B) geschaltet ist, oder zum Anpassen des zweiten Lade- und Entladesignals auf den zweiten Messanschluss (B) geschaltet ist, wenn die Ausgangsspannung der Integratorschaltung (7) auf den ersten Messanschluss (A) geschaltet ist.

5. Auswerteschaltung nach einem der Ansprüche 1 bis 4, **dadurch gekennzeichnet, dass** der erste Messanschluss (A) mit einer ersten Binarisierungsschaltung (4) und der zweite Messanschluss (B) mit einer zweiten Binarisierungsschaltung (5) verbunden ist, wobei die erste und zweite Binarisierungsschaltung (4, 5) vorzugsweise jeweils durch eine Schmitt-Trigger-Schaltung implementiert sind.

6. Auswerteschaltung nach einem der Ansprüche 1 bis 5, **dadurch gekennzeichnet, dass** die Komparatorschaltung (6) ein D-Flipflop (IC2A) mit einem Takteingang (CLK) und einem Dateneingang (D) umfasst.

7. Auswerteschaltung nach Anspruch 5 und 6, **dadurch gekennzeichnet, dass** ein Ausgang der ersten Binarisierungsschaltung (4) mit dem Takteingang (CLK) des D-Flipflops (IC2A) und ein Ausgang der zweiten Binarisierungsschaltung (5) mit dem Dateneingang (D) des D-Flipflops (IC2A) verbunden ist.

8. Auswerteschaltung nach einem der Ansprüche 1 bis 7, **dadurch gekennzeichnet, dass** die Integratorschaltung (7) mittels eines Operationsverstärkers (IC4A) implementiert ist, wobei der nicht-invertierende Eingang des Operationsverstärkers (IC4A) vorzugsweise mit einer Spannung größer als Null Volt verbunden ist und wobei die Spannung größer als Null Volt vorzugsweise über einen Spannungsteiler (8) aus einer Versorgungsspannung (Ucc) der Auswerteschaltung (1) abgeleitet ist.

9. Auswerteschaltung nach einem der Ansprüche 1 bis 8, **gekennzeichnet durch** einen Takteingang (T), wobei der Takteingang (T) mit der Lade- und Entladeschaltung (2) verbunden ist und wobei die Lade- und Entladeschaltung (2) dazu ausgebildet ist, aus einem an dem Takteingang (T) anliegenden Signal das erste und das zweite Lade- und Entladesignal abzuleiten, wobei die Lade- und Entladeschaltung (2) dann vorzugsweise durch einen Widerstand oder eine Verschaltung mehrerer Widerstände (R9, R10) gebildet ist.

10. Auswerteschaltung nach Anspruch 9, **gekennzeichnet durch** eine Taktgeberschaltung (3), wobei ein Ausgang (G) der Taktgeberschaltung (3) mit dem Takteingang (T) verbunden ist.

11. System zum Auswerten eines kapazitiven oder eines induktiven Sensors, umfassend:
eine erste Auswerteschaltung (11) nach einem der Ansprüche 1 bis 10,
eine zweite Auswerteschaltung (12) nach einem der Ansprüche 1 bis 10,
einen ersten kapazitiven oder induktiven Sensor (14) mit zwei Sensorelementen und
ein Referenzelement (16),
wobei das erste Sensorelement des ersten Sensors (14) mit einem ersten Messanschluss (A1) der ersten Auswerteschaltung (11) und das zweite Sensorelement des ersten Sensors (14) mit einem zweiten Messanschluss (B1) der ersten Auswerteschaltung (11) verbunden ist,
wobei das Referenzelement (16) mit einem zweiten Messanschluss (B3) der zweiten Auswerteschaltung (12) verbunden ist und
wobei der erste Messanschluss (A3) der zweiten Auswerteschaltung (12) über jeweils einen Koppelwiderstand (RA1, RB1) mit dem ersten und dem zweiten Messanschluss (A1, B1) der ersten Auswerteschaltung (11) verbunden ist.

12. System nach Anspruch 11, **gekennzeichnet durch** eine dritte Auswerteschaltung (13) nach einem der Ansprüche 1 bis 10 und einen zweiten kapazitiven oder induktiven Sensor (15) mit zwei Sensorelementen, wobei das erste Sensorelement des zweiten Sensors (15) mit einem ersten Messanschluss (A2) der dritten Auswerteschaltung (13) und das zweite Sensorelement des zweiten Sensors (15) mit einem zweiten Messanschluss (B2) der dritten Auswerteschaltung (13) verbunden ist und wobei der erste Messanschluss (A3) der zweiten Auswerteschaltung (12) zusätzlich über jeweils einen Koppelwiderstand (RA2, RB2) mit dem ersten und dem zweiten Messanschluss (A2, B2) der dritten Auswerteschaltung (13) verbunden ist.

13. System nach Anspruch 12, **dadurch gekennzeichnet, dass** die Sensorelemente des ersten Sensors (14) und die Sensorelemente des zweiten Sensors (15) jeweils symmetrisch aufgebaut sind, wobei die Symmetrieachse des ersten Sensors (14) und die Symmetrieachse des zweiten Sensors (15) vorzugsweise senkrecht zueinander angeordnet sind, und/oder
dass die Sensorelemente des ersten Sensors (14) und die Sensorelemente des zweiten Sensors (15) durch Kreisbögen oder durch Kreissektoren gebildet sind.

14. System nach einem der Ansprüche 11 bis 13, **gekennzeichnet durch** eine Taktgeberschaltung, wobei ein durch die Taktgeberschaltung erzeugtes Taktsignal jeweils in einen Takteingang (T) der Auswerteschaltung/en (11, 12, 13) eingegeben wird, und/oder
dass eine der Auswerteschaltungen (11, 12, 13) eine Taktgeberschaltung (3) enthält und dazu ausgebildet ist, ein durch die Taktgeberschaltung (3) erzeugtes Taktsignal über einen Taktausgang (G) auszugeben, und dass der Taktausgang (G) mit einem Takteingang (T) der weiteren Auswerteschaltung/en (11, 12, 13) des Systems verbunden ist.

15. Verfahren zum Auswerten eines kapazitiven oder eines induktiven Sensors unter Verwendung einer Auswerteschaltung nach einem der Ansprüche 1 bis 10, umfassend die Schritte:
Erzeugen eines ersten und eines zweiten Lade- und Entladesignals,
wiederholtes Laden und Entladen eines ersten Sensorelements des Sensors (14, 15) mittels des ersten Lade- und Entladesignals,
wiederholtes Laden und Entladen eines zweiten Sensorelements des Sensors (14, 15) oder eines Referenzelements (16) mittels des zweiten Lade- und Entladesignals,
Vergleichen des zeitlichen Verhaltens des ersten Lade- und Entladesignals mit dem zeitlichen Verhalten des zweiten Lade- und Entladesignals,
Ändern einer Ausgangsspannung einer Integratorschaltung (7) in Abhängigkeit von dem Ergebnis des Vergleichs der zeitlichen Verhalten,
Anpassen des ersten Lade- und Entladesignals und/oder des zweiten Lade- und Entladesignals in Abhängigkeit von der Ausgangsspannung der Integratorschaltung (7) und
Ableiten und Ausgeben eines Messsignals aus der Ausgangsspannung der Integratorschaltung (7) als ein Maß für die Abweichung der Impedanzen des ersten und des zweiten Sensorelements oder der Impedanzen des ersten Sensorelements und des Referenzelements.

## Claims

1. Evaluation circuit for evaluating a capacitive or an inductive sensor, comprising:
a first and a second measurement connection (A, B), wherein the first measurement connection (A) is constructed to connect a first sensor element of the sensor (14, 15) and the second measurement connection (B) is constructed to connect a second sensor element of the sensor (14, 15) or a reference element (16),
a charging and discharging circuit (2) which is constructed to output a first charging and discharging signal to the first measurement connection (A) and to output a second charging and discharging signal to the second measurement connection (B),
a comparator circuit (6) which compares the temporal behaviour of the first charging and discharging signal with the temporal behaviour of the second charging and discharging signal, and
an integrator circuit (7) which is connected to an output of the comparator circuit (6) and whose output voltage changes depending on the voltage at the output of the comparator circuit (6), and
wherein the output voltage of the integrator circuit (7) is switched to adapt the first charging and discharging signal to the first measurement connection (A) or to adapt the second charging and discharging signal to the second measurement connection (B),
wherein a measurement signal at an output (10) of the evaluation circuit (1) is derived from the output voltage of the integrator circuit (7) and wherein the measurement signal is a measurement for the deviation of the impedances of the first and the second sensor elements or the impedances of the first sensor element and the reference element.

2. Evaluation circuit according to claim 1, **characterised by** an inverting circuit (9), preferably an inverting amplifier, wherein the output voltage of the integrator circuit (7) is entered into an input of the inverting circuit, wherein an output voltage of the inverting circuit (9) relative to a reference voltage (Ucc/2) changes in the opposite direction to the output voltage of the integrator circuit (7).

3. Evaluation circuit according to claim 1 and claim 2, **characterised in that** the measurement signal is formed by the voltage between the output voltage of the integrator circuit (7) and the output voltage of the inverting circuit (9).

4. Evaluation circuit according to claim 1 and claim 2 or claim 3, **characterised in that** the output voltage of the inverting circuit (9) is switched to adapt the first charging and discharging signal to the first measurement connection (A) when the output voltage of the integrator circuit (7) is switched to the second measurement connection (B) or to adapt the second charging and discharging signal to the second measurement connection (B) when the output voltage of the integrator circuit (7) is connected to the first measurement connection (A).

5. Evaluation circuit according to any one of claims 1 to 4, **characterised in that** the first measurement connection (A) is connected to a first binarisation circuit (4) and the second measurement connection (B) is connected to a second binarisation circuit (5), wherein the first and the second binarisation circuits (4, 5) are preferably each implemented by means of a Schmitt trigger circuit.

6. Evaluation circuit according to any one of claims 1 to 5, **characterised in that** the comparator circuit (6) comprises a D-flipflop (IC2A) with a clock input (CLK) and a data input (D) .

7. Evaluation circuit according to claim 5 and claim 6, **characterised in that** an output of the first binarisation circuit (4) is connected to the clock input (CLK) of the D-flipflop (IC2A) and an output of the second binarisation circuit (5) is connected to the data input (D) of the D-flipflop (IC2A).

8. Evaluation circuit according to any one of claims 1 to 7, **characterised in that** the integrator circuit (7) is implemented by means of an operational amplifier (IC4A), wherein the non-inverted input of the operational amplifier (IC4A) is preferably connected to a voltage greater than zero Volt and wherein the voltage greater than zero Volt is preferably derived via a voltage divider (8) from a supply voltage (Ucc) of the evaluation circuit (1).

9. Evaluation circuit according to any one of claims 1 to 8, **characterised by** a clock input (T), wherein the clock input (T) is connected to the charging and discharging circuit (2), and wherein the charging and discharging circuit (2) is constructed to derive the first and the second charging and discharging signal from a signal present at the clock input (T), wherein the charging and discharging circuit (2) is then preferably formed by a resistor or an interconnection of a plurality of resistors (R9, R10).

10. Evaluation circuit according to claim 9, **characterised by** a clock generator circuit (3), wherein an output (G) of the clock generator circuit (3) is connected to the clock input (T) .

11. System for evaluating a capacitive or an inductive sensor, comprising:
a first evaluation circuit (11) according to any one of claims 1 to 10,
a second evaluation circuit (12) according to any one of claims 1 to 10,
a first capacitive or inductive sensor (14) having two sensor elements, and
a reference element (16),
wherein the first sensor element of the first sensor (14) is connected to a first measurement connection (A1) of the first evaluation circuit (11) and the second sensor element of the first sensor (14) is connected to a second measurement connection (B1) of the first evaluation circuit (11),
wherein the reference element (16) is connected to a second measurement connection (B3) of the second evaluation circuit (12), and
wherein the first measurement connection (A3) of the second evaluation circuit (12) is connected by means of a coupling resistor (RA1, RB1) to the first and the second measurement connection (A1, B1) of the first evaluation circuit (11).

12. System according to claim 11, **characterised by** a third evaluation circuit (13) according to any one of claims 1 to 10 and by a second capacitive or inductive sensor (15) having two sensor elements, wherein the first sensor element of the second sensor (15) is connected to a first measurement connection (A2) of the third evaluation circuit (13) and the second sensor element of the second sensor (15) is connected to a second measurement connection (B2) of the third evaluation circuit (13) and wherein the first measurement connection (A3) of the second evaluation circuit (12) is additionally connected by means of a coupling resistor (RA2, RB2) to the first and the second measurement connection (A2, B2) of the third evaluation circuit (13).

13. System according to claim 12, **characterised in that** the sensor elements of the first sensor (14) and the sensor elements of the second sensor (15) are constructed in each case in a symmetrical manner, wherein the axis of symmetry of the first sensor (14) and the axis of symmetry of the second sensor (15) are preferably arranged perpendicularly to each other, and/or
**in that** the sensor elements of the first sensor (14) and the sensor elements of the second sensor (15) are formed by circular arcs or circle sectors.

14. System according to any one of claims 11 to 13, **characterised by** a clock generator circuit, wherein a clock signal produced by the clock generator circuit is entered in each case into a clock input (T) of the evaluation circuit(s) (11, 12, 13), and/or
in that one of the evaluation circuits (11, 12, 13) contains a clock generator circuit (3) and is constructed to output a clock signal produced by the clock generator circuit (3) via a clock output (G), and in that the clock output (G) is connected to a clock input (T) of the additional evaluation circuit(s) (11, 12, 13) of the system.

15. Method for evaluating a capacitive or an inductive sensor using an evaluation circuit according to any one of claims 1 to 10, comprising the steps of:
producing a first and a second charging and discharging signal,
repeatedly charging and discharging a first sensor element of the sensor (14, 15) by means of the first charging and discharging signal,
repeatedly charging and discharging a second sensor element of the sensor (14, 15) or a reference element (16) by means of the second charging and discharging signal,
comparing the temporal behaviour of the first charging and discharging signal with the temporal behaviour of the second charging and discharging signal,
changing an output voltage of an integrator circuit (7) in accordance with the result of the comparison of the temporal behaviour,
adapting the first charging and discharging signal and/or the second charging and discharging signal in accordance with the output voltage of the integrator circuit (7), and
deriving and outputting a measurement signal from the output voltage of the integrator circuit (7) as a measurement for the deviation of the impedances of the first and second sensor element or the impedances of the first sensor element and the reference element.

## Revendications

1. Circuit d'évaluation destiné à l'évaluation d'un capteur capacitif ou d'un capteur inductif, comprenant :
un premier et un deuxième raccord de mesure (A, B), le premier raccord de mesure (A) étant constitué pour le raccordement d'un premier élément de capteur du capteur (14, 15), et le deuxième raccord de mesure (B) pour le raccordement d'un deuxième élément de capteur du capteur (14, 15) ou d'un élément de référence (16),
un circuit de charge et de décharge (2), qui est constitué pour l'émission d'un premier signal de charge et de décharge vers le premier raccord de mesure (A) et pour l'émission d'un deuxième signal de charge et de décharge au deuxième raccord de mesure (B),
un circuit comparateur (6) qui compare le comportement dans le temps du premier signal de charge et de décharge avec le comportement dans le temps du deuxième signal de charge et de décharge, et
un circuit intégrateur (7) qui est raccordé à une sortie du circuit comparateur (6), et dont la tension de sortie varie en fonction de la tension à la sortie du circuit comparateur (6), et
la tension de sortie du circuit intégrateur (7) étant couplée au premier raccord de mesure (A) pour l'adaptation du premier signal de charge et de décharge ou étant couplée au deuxième raccord de mesure (B) pour l'adaptation du deuxième signal de charge et de décharge,
un signal de mesure sur une sortie (10) du circuit d'évaluation (1) étant dérivé de la tension de sortie du circuit intégrateur (7), et le signal de mesure étant une mesure de l'écart des impédances du premier et du deuxième élément de capteur ou des impédances du premier élément de capteur et de l'élément de référence.

2. Circuit d'évaluation selon la revendication 1, **caractérisé par** un circuit inverseur (9), de préférence un amplificateur inverseur, la tension de sortie du circuit intégrateur (7) étant introduite dans une entrée du circuit inverseur, une tension de sortie du circuit inverseur (9) variant relativement à une tension de référence (Ucc/2) dans une direction opposée comme la tension de sortie du circuit intégrateur (7).

3. Circuit d'évaluation selon les revendications 1 et 2, **caractérisé en ce que** le signal de mesure est formé par la tension entre la tension de sortie du circuit intégrateur (7) et la tension de sortie du circuit inverseur (9).

4. Circuit d'évaluation selon les revendications 1 et 2 ou la revendication 3, **caractérisé en ce que** la tension de sortie du circuit inverseur (9) est couplée au premier raccord de mesure (A) pour l'adaptation du premier signal de charge et de décharge quand la tension de sortie du circuit intégrateur (7) est couplée au deuxième raccord de mesure (B), ou est couplée au deuxième raccord de mesure (B) pour l'adaptation du deuxième signal de charge et de décharge quand la tension de sortie du circuit intégrateur (7) est couplée au premier raccord de mesure (A).

5. Circuit d'évaluation selon l'une des revendications 1 à 4, **caractérisé en ce que** le premier raccord de mesure (A) est raccordé à un premier circuit de binarisation (4), et le deuxième raccord de mesure (B) est raccordé à un deuxième circuit de binarisation (5), le premier et le deuxième circuit de binarisation (4, 5) étant de préférence respectivement mis en œuvre par un circuit de bascule de Schmitt.

6. Circuit d'évaluation selon l'une des revendications 1 à 5, **caractérisé en ce que** le circuit comparateur (6) comprend une bascule bistable de type D (IC2A) avec une entrée d'horloge (CLK) et une entrée de données (D).

7. Circuit d'évaluation selon les revendications 5 et 6, **caractérisé en ce qu'**une sortie du premier circuit de binarisation (4) est raccordée à l'entrée d'horloge (CLK) de la bascule bistable de type D (IC2A), et une sortie du deuxième circuit de binarisation (5) est raccordée à l'entrée de données (D) de la bascule bistable de type D (IC2A).

8. Circuit d'évaluation selon l'une des revendications 1 à 7, **caractérisé en ce que** le circuit intégrateur (7) est mis en œuvre au moyen d'un amplificateur opérationnel (IC4A), l'entrée non inverseuse de l'amplificateur opérationnel (IC4A) étant de préférence raccordée à une tension supérieure à zéro volt, et la tension supérieure à zéro volt étant de préférence dérivée par le biais d'un diviseur de tension (8) à partir d'une tension d'alimentation (Ucc) du circuit d'évaluation (1).

9. Circuit d'évaluation selon l'une des revendications 1 à 8, **caractérisé par** une entrée d'horloge (T), l'entrée d'horloge (T) étant raccordée au circuit de charge et de décharge (2), et le circuit de charge et de décharge (2) étant constitué pour dériver le premier et le deuxième signal de charge et de décharge à partir d'un signal présent à l'entrée d'horloge (T), le circuit de charge et de décharge (2) étant alors de préférence formé par une résistance ou par une interconnexion de plusieurs résistances (R9, R10).

10. Circuit d'évaluation selon la revendication 9, **caractérisé par** un circuit d'horloge (3), une sortie (G) du circuit d'horloge (3) étant raccordée à l'entrée d'horloge (T).

11. Système d'évaluation d'un capteur capacitif ou d'un capteur inductif, comprenant :
un premier circuit d'évaluation (11) selon l'une des revendications 1 à 10,
un deuxième circuit d'évaluation (12) selon l'une des revendications 1 à 10,
un premier capteur capacitif ou inductif (14) avec deux éléments de capteur, et
un élément de référence (16),
le premier élément de capteur du premier capteur (14) étant raccordé à un premier raccord de mesure (A1) du premier circuit d'évaluation (11), et le deuxième élément de capteur du premier capteur (14) étant raccordé à un deuxième raccord de mesure (B1) du premier circuit d'évaluation (11),
l'élément de référence (16) étant raccordé à un deuxième raccord de mesure (B3) du deuxième circuit d'évaluation (12), et
le premier raccord de mesure (A3) du deuxième circuit d'évaluation (12) étant, par le biais de respectivement une résistance de couplage (RA1, RB1), raccordé au premier et au deuxième raccord de mesure (A1, B1) du premier circuit d'évaluation (11).

12. Système selon la revendication 11, **caractérisé par** un troisième circuit d'évaluation (13) selon l'une des revendications 1 à 10, et par un deuxième capteur capacitif ou inductif (15) avec deux éléments de capteur, le premier élément de capteur du deuxième capteur (15) étant raccordé à un premier raccord de mesure (A2) du troisième circuit d'évaluation (13), et le deuxième élément de capteur du deuxième capteur (15) étant raccordé à un deuxième raccord de mesure (B2) du troisième circuit d'évaluation (13), et le premier raccord de mesure (A3) du deuxième circuit d'évaluation (12) étant en plus raccordé par le biais de respectivement une résistance de couplage (RA2, RB2) au premier et au deuxième raccord de mesure (A2, B2) du troisième circuit d'évaluation (13).

13. Système selon la revendication 12, **caractérisé en ce que** les éléments de capteur du premier capteur (14) et les éléments de capteur du deuxième capteur (15) sont respectivement réalisés de façon symétrique, l'axe de symétrie du premier capteur (14) et l'axe de symétrie du deuxième capteur (15) étant de préférence disposés perpendiculairement l'un à l'autre, et/ou
**en ce que** les éléments de capteur du premier capteur (14) et les éléments de capteur du deuxième capteur (15) sont formés par des arcs de cercle ou des secteurs de cercle.

14. Système selon l'une des revendications 11 à 13, **caractérisé par** un circuit d'horloge, un signal d'horloge produit par le circuit d'horloge étant respectivement introduit dans une entrée d'horloge (T) des circuits d'évaluation (11, 12, 13), et/ou
en ce que l'un des circuits d'évaluation (11, 12, 13) contient un circuit d'horloge (3) et est constitué pour émettre par le biais d'une sortie d'horloge (G) un signal d'horloge produit par le circuit d'horloge (3), et en ce que la sortie d'horloge (G) est raccordée à une entrée d'horloge (T) de l'autre/des autres circuits d'évaluation (11, 12, 13) du système.

15. Procédé d'évaluation d'un capteur capacitif ou d'un capteur inductif, avec utilisation d'un circuit d'évaluation selon l'une des revendications 1 à 10, comprenant les étapes :
production d'un premier et d'un deuxième signal de charge et de décharge,
chargement et de déchargement répétés d'un premier élément de capteur du capteur (14, 15) au moyen du premier signal de charge et de décharge,
chargement et de déchargement répétés d'un deuxième élément de capteur du capteur (14, 15) ou d'un élément de référence (16) au moyen du deuxième signal de charge et de décharge,
comparaison du comportement dans le temps du premier signal de charge et de décharge avec le comportement dans le temps du deuxième signal de charge et de décharge,
variation d'une tension de sortie d'un circuit intégrateur (7) en fonction du résultat de la comparaison des comportements dans le temps,
adaptation du premier signal de charge et de décharge et/ou du deuxième signal de charge et de décharge en fonction de la tension de sortie du circuit intégrateur (7), et
dérivation et émission d'un signal de mesure à partir de la tension de sortie du circuit intégrateur (7) en tant que mesure de l'écart des impédances du premier et du deuxième élément de capteur ou des impédances du premier élément de capteur et de l'élément de référence.
